# EUROPÄISCHE PATENTSCHRIFT

(11) **EP 1 852 708 B1**
(45) Veröffentlichungstag und Bekanntmachung des Hinweises auf die Patenterteilung: **29.10.2008**
(21) Anmeldenummer: 07008489.2
(22) Anmeldetag: 26.04.2007
(51) Int. Cl.: G01R 33/34, G01R 33/30

(54) **Gekühlter, kuppelbarer NMR-Probenkopf**
Cooled, detachable NMR probe head
Sonde RMN refroidie pouvant être couplée

(30) Priorität: 03.05.2006 DE 102006020774
(43) Veröffentlichungstag der Anmeldung: 07.11.2007
(73) Patentinhaber: Bruker BioSpin AG, 8117 Fällanden (CH)
(72) Erfinder: Marek, Daniel, Dr., 5103 Möriken (CH); Sacher, Marco, 8610 Uster (CH); Leutenegger, Tobias, Dr., 8057 Zürich (CH)
(74) Vertreter: Kohler Schmid Möbus

(56) Entgegenhaltungen:
- EP-A- 1 512 983
- EP-A2- 1 471 363
- DE-C1- 19 946 371
- JP-A- 2004 037 238

## Beschreibung

Die Erfindung betrifft einen Magnetresonanz(=MR)-Probenkopf mit einer Detektionsvorrichtung mit, mindestens einem von einer Kühlvorrichtung kryogen gekühlten Antennensystem, sowie mit einem gekühlten Vorverstärker in einem Vorverstärkergehäuse, welches örtlich getrennt von der Detektionsvorrichtung angeordnet ist, und mit einer thermisch isolierenden Verbindungseinrichtung, über die die Detektionsvorrichtung und das Vorverstärkergehäuse miteinander verbunden sind, wobei die Verbindungseinrichtung mindestens eine Kühlleitung für die Zu- und/oder Rückleitung eines Kühl-Fluids, sowie mindestens eine Hochfrequenz(HF)-Leitung zur Übertragung der elektrischen Signale umfasst.

Gekühlte MR-Probenköpfe sind beispielsweise aus [1] - [3] bekannt und werden für die Detektion von MR-Signalen aus einer Probe verwendet. Dabei ist die Empfangsspule gekühlt. Diese Empfangsspule kann aus normal leitenden Metall, z.B. Kupfer oder Aluminium oder aber aus Supraleitermaterialien bestehen, insbesondere aus Hochtemperatur-Supraleitern (HTSC).

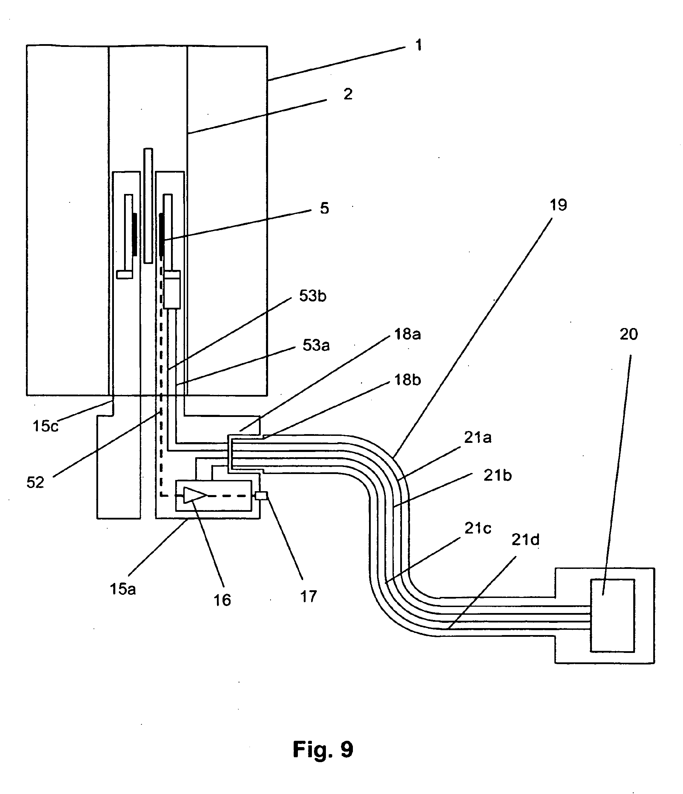

Der aus [3] bekannte MR-Probenkopf stellt ein mit einem Kryokühler **20** gekühltes System dar, wobei sich der Kryokühler 20 in einer gewissen Entfernung vom Probenkopf selbst befindet. Bei diesem Kryokühler 20 handelt es sich typischerweise um einen Gifford-McMahon Kühler, es kann aber auch ein Pulsrohr-Kühler vorgesehen sein. Der Probenkopf wird in der Regel über eine flexible Transferleitung **19** mit weiterführenden Leitungen **21a, 21b, 21c 21d** gekühlt, die zu einem Vorverstärker **16** beziehungsweise über Kühlleitungen **53a, 53b** zur Empfangsspule 5 führen. Obwohl es sich bei den Kühlleitungen 53a, 53b um Röhrchen o.ä. handelt, sind sie in dieser Darstellung wie auch in den anderen Figuren nur als ein Strich dargestellt. Die Transferleitung 19 dient dazu, die Entfernung zum Kryokühler 20 zu überbrücken und auch Vibrationen vom Probenkopf fernzuhalten. In dieser Transferleitung 19 zirkuliert ein Wärmetransportmedium (Kühlfluid), typischerweise kaltes, gasförmiges Helium. Der Probenkopf selbst umfasst üblicherweise mindestens eine Empfangsspule 5 und mindesten einen Vorverstärker 16, welche über eine starre Verbindungseinrichtung **15c** mit HF-Leitungen **52** miteinander verbunden sind. Der gesamte Probenkopf ist als eine starre Einheit ausgeführt. Ein derartiger MR-Probenkopf ist in **Fig. 9** in einer Raumtemperaturbohrung **2** eines Magneten 1 für ein vertikales Magnetsystem dargestellt.

Mit einer solchen Anordnung ist eine hohe Performance möglich, denn die HF-Empfangsspule 5 wird in der Raumtemperaturbohrung 2 des Magneten 1 bei einer sehr tiefen Temperatur (z.B. 20K), und der Vorverstärker 16 bei einer so tiefen Temperatur betrieben, dass er noch einwandfrei funktioniert (z.B. 77K). Auch die HF-Leitung 52 zwischen der Empfangspule 5 und dem Vorverstärker 16 befindet sich auf einer tiefen Temperatur. Die Temperatur geht dann typischerweise entlang der HF-Leitung 52 von 20 K auf 77 K über, wobei hier die Geometrie (Insbesondere der Querschnitt der Kabel der HF-Leitung 52) so gewählt wird, dass ein Optimum zwischen der Minimierung der HF-Leitungsverluste auf der einen Seite und der Minimierung des Wärmeeintrags in die kalte Empfangsspule 5, der sich durch die Wärmeleitfähigkeit der HF-Leitung 52 ergibt, andererseits, erzielt wird. Somit ist das S/N-Verhältnis des Systems praktisch optimal. Nach der Verstärkung mit dem gekühlten Vorverstärker 16 wird das Signal schlussendlich an einen Signalausgang **17** zur weiteren Signalverarbeitung ausgegeben. Die gesamte Kühlung des MR-Probenkopfs kann mit einem einzigen Kryokühler 20 (Gifford-McMahon oder auch Pulsrohr-Kühlkopf) stattfinden.

Für den Ein- und Ausbau des MR-Probenkopfs kann der MR-Probenkopf vom Kryokühler 20 mittels einer Kupplung mit Kupplungsteilen **18a, 18b** getrennt werden. Eine solche Kupplung ist z.B. in [5] und [3] offenbart. Der gesamte Probenkopf ist mit seinem typischerweise großen Vorverstärker 16 sowie einem zugehörigen Vorverstärkergehäuse **15a** jedoch recht schwer, so dass ein Ein-/Ausbau im Allgemeinen zwei Personen erfordert.

Insbesondere bei Magnetresonanz-Bildgebung (MRI) werden jedoch oft viele verschiedene HF-Messspulen verwendet. Diese werden gebraucht, um eine optimale Anpassung an das Messobjekt sowie die spezielle Untersuchung zu ermöglichen. Dazu zählen z.B. Ganzkörperspulen (z.B. Birdcage-Resonator), oder aber Oberflächenspulen. Es werden auch verschiedene Größen oder Anordnungen verwendet, z.B. solche für die Untersuchung vom Gehirn, oder solche von Gelenken oder auch der Wirbelsäule. Des Weiteren finden in zunehmendem Maße auch Array-Spulen Verwendung.

Die oben beschriebene Anordnung kann auch für verschiedene Lebewesen bestimmt sein, z.B. für eine Maus oder aber für eine Ratte. Dies bedingt natürlich auch eine Skalierung der Detektionsvorrichtung auf verschiedene Größen.

Ähnliches gilt auch für so genannte Microimaging-Systeme, die bei Magneten mit kleineren Raumtemperaturbohrungen, aber sehr hohen Feldstärken (bis über 17T) verwendet werden, um kleinere Proben abzubilden. Auch hier ist eine Vielfalt von Empfangsspulen notwendig.

Bei einer fest zusammengebauten Einheit von Empfangsspule(n) und Vorverstärker muss für jede solche Anwendung ein kompletter Probenkopf angeschafft werden. Dieser beinhaltet auch die aufwändigen gekühlten Vorverstärker, sowie einen großen Teil der kryotechnischen Hardware. Dies bildet neben dem hohen Preis, der für jede Konfiguration bezahlt werden muss, auch einen Aufwand in der Handhabung, da für jeden Wechsel der ganze Probenkopf mit der schweren Vorverstärkereinheit gewechselt werden muss.

Aufgabe der vorliegenden Erfindung ist es daher, einen MR-Probenkopf vorzuschlagen, der universell verwendbar, und günstig für weitere Messanordnungen aufrüstbar ist.

Diese Aufgabe wird erfindungsgemäß dadurch gelöst, dass die Verbindungseinrichtung inklusive ihrer HF- und Kühlleitungen mittels einer Kupplung vom Vorverstärkergehäuse abtrennbar ist.

Die erfindungsgemäße Kupplung verbindet im Wesentlichen die Detektionsvorrichtung mit dem Vorverstärker auf eine trennbare Art und Weise, so dass der Vorverstärker für verschiedene Anwendungen verwendet werden kann und lediglich die Detektionsvorrichtung ausgewechselt werden muss. Hierdurch reduzieren sich auch die Anschaffungskosten der benötigten Komponenten.

Vorzugsweise handelt es sich bei dem erfindungsgemäßen MR-Probenkopf um einen Probenkopf für Magnetresonanz-Bildgebung(=MRI)-Anwendungen oder für Kernspinresonanz(NMR)-Spektroskopie. Insbesondere bei MRI-Anwendungen, bei denen viele unterschiedliche Detektionsvorrichtungen zum Einsatz kommen, erweist sich der erfindungsgemäße kuppelbare MR-Probenkopf als vorteilhaft.

Statt den MR-Probenkopf mittels einer einzigen Kühlleitung zu kühlen, wobei das Kühlmittel an den zu kühlenden Komponenten verdampft, ist es bei dem erfindungsgemäßen MR-Probenkopf besonders vorteilhaft, wenn zwei Kühlleitungen vorgesehen sind, die Teil eines ersten Kühlkreislaufs sind. Hierbei besteht die Möglichkeit das Kühlmittel rückzukühlen oder auch gegebenenfalls rückzuverflüssigen und wieder zu verwenden.

Bei einer bevorzugten Ausführungsform der Erfindung weist die Kupplung eine Fluid-Kupplungsvorrichtung mit Fluidkoppelelementen zum Koppeln der mindestens einen Kühlleitung, die zur Detektionsvorrichtung führt, an mindestens eine vorverstärkergehäuseseitigen weiterführende Kühlleitungsabschnitt, sowie eine HF-Leitungs-Kupplungsvorrichtung auf, wobei die HF-Leitungs-Kupplungsvorrichtung mindestens ein erstes HF- Leitungskoppelelementen, insbesondere einen antennensystemseitigen HF-Stecker, und mindestens ein zweites HF-Leitungskoppelelementen, insbesondere eine HF-Buchse, zur Ankopplung der HF-Leitungen zum Signaleingang des Vorverstärkers, umfasst.

Besonders vorteilhaft ist es, wenn für mindestens ein Paar von ersten und zweiten HF- Leitungskoppelelementen ein Federelement vorgesehen ist, welches das erste HF-Leitungskoppelelement und das zugehörige zweite HF-Leitungskoppelelement gegeneinander drückt. Diese Ausführung gewährleistet auch bei etwaigen Dimensionsänderungen der Komponenten einen einwandfreien Kontakt der HF-Buchen mit den HF-Leitungskoppelelementen.

Vorzugsweise werden die HF-Leitungskoppelelemente und/oder eine Vakuumummantellung, welche die ersten HF-Leitungskoppelelemente umgibt, mit einer thermischen Stufe gekühlt, so dass ein Wärmeeintrag über die HF-Leitungskupplungsvorrichtung in die HF-Leitung verhindert wird.

Bei einer Weiterbildung dieser Ausführungsform ist die thermische Stufe der HF-Leitungskoppelelemente mit einem Wärmetauscher des Vorverstärkers, einer thermischen Stufe des Vorverstärkers oder dem Vorverstärker selbst thermisch verbunden.

Die Elektronik des gekühlten Vorverstärkers wird vorzugsweise durch einen, von der mindestens einen Kühlleitung separaten, zweiten Kühlkreislauf gekühlt.

Zur Kühlung der thermischen Stufe der HF-Leitungskoppelelemente ist vorzugsweise ein Wärmetauscher vorgesehen, der in der Vorlaufleitung des ersten oder zweiten Kühlkreislaufs angeordnet ist.

Diese thermische Stufe weist im Betrieb vorzugsweise eine Temperatur unterhalb der Vorverstärkertemperatur auf, damit kein unnötiger Wärmeeintrag auf den Vorverstärker erfolgt.

Besonders vorteilhaft ist eine Ausführungsform des erfindungsgemäßen MR-Probenkopfs, bei dem die Kupplung einen Vakuumanschluss zur Ankopplung an eine Vakuumleitung umfasst. Die Verbindungseinrichtung kann somit zu Isolationszwecken über die Vakuumleitung evakuiert werden.

Eine besonders vorteilhafte Ausführungsform des erfindungsgemäßen MR-Probenkopfs ergibt sich, wenn die Verbindungseinrichtung als eine mechanisch flexible Verbindungsleitung mit mechanisch flexiblen HF- und Kühlleitungen ausgeführt ist. Durch die flexible Ausführung der Verbindungseinrichtung als auch der HF- und Kühlleitungen wird der Platzbedarf für den Ein- und Ausbau des MR-Probenkopfs minimiert. Die Detektionsvorrichtung, die den Teil des Probenkopfes bildet, der in unmittelbarer Nähe des zu untersuchenden Objekts arbeitet und für den Empfang der HF-Signale zuständig ist, kann somit rasch in den Magneten eingebaut und in Betrieb genommen werden kann. Ebenso kann nach Abschluss der Messungen die Detektionsvorrichtung schnell und einfach außer Betrieb gesetzt und aus der Raumtemperaturbohrung des Magneten entfernt werden. Insbesondere bei einem häufigen Wechsel von Untersuchungsmethoden und somit der Detektionsvorrichtung können unproduktiven Stillstandzeiten des sehr teueren Magnetsystems reduziert werden. Durch die erfindungsgemäße Kupplung in Kombination mit der flexibeln Verbindungsleitung kann der Vorverstärker beim Auswechseln der Detektionsvorrichtung im jeweiligen MR-System verbleiben. Das Vorverstärkergehäuse kann während des Auswechselns der Detektionsvorrichtung evakuiert bleiben.

Eine besonders bevorzugte Ausführungsform der Erfindung sieht vor, dass jeweils eine oder mehrere HF-Leitungen einer einzelnen Kühlleitung zugeteilt sind und dort zusammen mit der zugeteilten Kühlleitung jeweils ein Leitungspaket bilden. Innerhalb eines Leitungspakets sind die Leitungen dicht beieinander angeordnet, so dass zwischen den einzelnen Leitungen innerhalb des Leitungspaketes ein Temperaturausgleich stattfinden kann.

Bei einer Weiterbildung dieser Ausführungsform sind die Kühlleitung und die der Kühlleitung zugeteilten HF-Leitungen eines einzelnen Leitungspaketes in, vorzugsweise regelmäßigen, Abständen über thermisch gut leitende Ankopplungselemente miteinander thermisch verbunden. Diese Ankopplungselemente können beispielsweise aus Kupfer gefertigt sein.

Eine weitere Weiterbildung sieht vor, dass zumindest eines der Leitungspakete mindestens ein elastisches Verstärkungselement, insbesondere einen Draht hoher mechanischer Festigkeit, enthält, wodurch eine Reduktion der mechanischen Zug- und Biegebeanspruchung der HF- und Kühlleitungen erreicht wird. Das Verstärkungselement kann z.B. aus Edelstahl sein.

Bei einer bevorzugten Ausführungsform sind die einzelnen Leitungspakete über die gesamte Länge der Verbindungsleitung, vorzugsweise mindestens einmal, um die Achse der Verbindungsleitung verdreht.

Besonders vorteilhaft ist es, wenn innerhalb der Leitungspakete die HF-Leitungen und/oder die elastischen Verstärkungselemente zwischen zwei Ankopplungselementen um im Wesentlichen 360 Grad oder ein ganzzahliges Vielfaches davon mit der Kühlleitung verdrillt, insbesondere um die Kühlleitung herum gewickelt angebracht sind. Hierdurch wird erreicht, dass die Gesamtlänge aller Leitungen zwischen den Ankopplungselementen bei einer Biegung weitgehend gleich bleibt. Dies hat zur Folge, dass beim Biegen der Verbindungsleitung keinerlei Beulen oder Knicken in den Leitungen auftritt. Es ist auch denkbar, dass die Kühlleitung um die HF-Leitungen und/oder die elastischen Verstärkungselemente, oder auch beide zusammen verdrillt sind. Auch kann die Kühlleitung um die HF-Leitung herum vorverdrillt angeordnet sein.

Die HF-Leitung des erfindungsgemäßen MR-Probenkopfs umfasst vorteilhafterweise ein flexibles Koaxialkabel mit vorzugsweise Polytetrafluorethylen (PTFE) Isolation, bei dem der Außenleiter aus einer Kombination von einem Metallgeflecht und einer spiralförmig gewickelten, elektrisch gut leitenden Metallfolie besteht.

Besonders vorteilhaft ist es, wenn die kalten Teile der Verbindungsleitung, insbesondere die Kühlleitungen sowie die HF-Leitungen, zur thermischen Isolation in einem Vakuum innerhalb mindestens eines flexiblen Außenmantels angeordnet sind. Auf diese Weise, insbesondere durch Superisolation, wird der Wärmeeintrag in die kalten Teile des MR-Probenkopfs minimiert. Die Verbindungsleitung kann auch zwei parallel geführte Schlauchleitungen als Außenmantel umfassen, wobei eine Schlauchleitung die Vor- und der andere die Rückleitung, mit je einer Anzahl zugeordneter HF-Leitungen beherbergt. Diese Anordnung hat den Vorteil, dass die beiden Schlauchleitungen je einen kleineren Durchmesser haben können, und somit flexibler gestaltet werden können. Eine Ausführungsform mit einem einzigen Außenmantel hingegen hat den Vorteil einer besserer thermischen Isolation aufgrund einer kleineren Gesamtoberfläche für einen gegebenen Querschnitt sowie einer (von außen) einfacheren, robusteren und sauberer aussehenden Anordnung, wie auch eines isotropen Biegeverhalten.

Bei einer besonders bevorzugten Ausführungsform werden der erste und der zweite Kühlkreislauf von derselben Kühlvorrichtung gekühlt, so dass sowohl die Kosten als auch der Platz für eine weitere Kühlvorrichtung eingespart werden kann.

Für die Kühlung der Komponenten des MR-Probenkopfs ist vorzugsweise Helium als Kühlfluid vorgesehen.

Es kann vorteilhaft sein, wenn die Kühlvorrichtung ein Gifford-Mc Mahon Kühler ist.

Alternativ dazu kann die Kühlvorrichtung ein Pulsrohrkühler sein.

Vorzugsweise wird das Antennensystem bei einer tieferen Temperatur betrieben als der Vorverstärker.

Bei einer Weiterbildung dieser Ausführungsform werden das Antennensystem bei einer Temperatur im Bereich von 4 - 40 K und der Vorverstärker bei einer Temperatur im Bereich von 40 - 100 K betrieben.

Bei einer besonders bevorzugten Ausführungsform des erfindungsgemäßen MR-Probenkopfs ist der Abstand zwischen dem Vorverstärker und dem vorverstärkerseitig letzten Ankopplungselement größer als der durchschnittliche Abstand zweier Ankopplungselemente. Zwischen der HF-Leitung und der Kühlleitung wird also auf der Strecke zwischen dem Vorverstärker und dem vorverstärkerseitig letzten Ankopplungselement kein Wärmekontakt ausgeführt, so dass die Temperatur der HF-Leitungen im Wesentlichen der Temperatur der Kühlleitungen bzw. der Temperatur der Empfangsspulen entspricht, und nur kurz vor dem Vorverstärker der Temperaturübergang zur Vorverstärkertemperatur stattfindet. Während also in einem großen Bereich entlang der HF-Leitung diese durch eine ausreichend dichte (eng benachbarte) Anordnung von Ankopplungselementen gekühlt wird, wird für den Temperaturübergang zum Vorverstärker diese Ankopplung auf der oben beschriebenen Strecke nicht mehr ausgeführt, so dass die Temperatur dann stetig steigen kann.

Bezüglich der Handhabbarkeit ist es von Vorteil, wenn die Masse der Teile der Detektionsvorrichtung weniger als 5kg beträgt.

Eine besonders bevorzugte Ausführungsform des erfindungsgemäßen MR-Probenkopfs sieht vor, dass der Vorverstärker mehrere parallele Vorverstärkerkanäle umfasst. Werden beispielsweise Array-Spulen als Antennensystem verwendet, benötigen diese mehrere Vorverstärkerkanäle, wobei jedem dieser Kanäle eine Empfangsspule zugeordnet ist, die sich an einem anderen Ort befindet. Jede der Empfangsspulen ist mit einem eigenen Vorverstärker verbunden. Dies ermöglicht durch die Parallelisierung der Messung eine wesentlich schnellere Datenaufnahme. Die Anordnung kann auch verschiedene Muster annehmen. Für eine Hirnabbildung können z.B. 2 × 2 Spulen in einer quadratischen Anordnung verwendet werden, für eine Rückenmarkuntersuchung wird hingegen ein lineares Array von 1 x4 Spulen bevorzugt.

Dabei kann es vorteilhaft sein, wenn der Vorverstärker mehrere, insbesondere 2, 3, 4, 6, 8, 12, oder 16 parallele Kanäle für den gleichen zu untersuchenden Kern, insbesondere 1H, umfasst.

Eine weitere Ausführungsform der Erfindung sieht vor, dass der Vorverstärker Kanäle für die Verstärkung der Signale der Kerne 31 P, 13C, 23Na, 19F, 170, 129Xe oder 2H umfasst.

In den Rahmen der Erfindung fällt auch ein MR-System mit einem zuvor beschriebenen erfindungsgemäßen Probenkopf.

Die Vorteile der Erfindung kommen besonders gut zu Geltung wenn das MR-System ein MRI- oder ein NMR-System ist.

Der erfindungsgemäße MR-Probenkopf bildet ein offenes System welches mit der Möglichkeit zur Verwendung unterschiedlicher Messeinsätze sehr universell verwendbar, günstig für weitere Messanordnungen aufrüstbar und bei einer optionalen Anordnung mit einer flexiblen Verbindungsleitung auch sehr gut und zeitsparend handhabbar ist.

Weitere Vorteile der Erfindung ergeben sich aus der Beschreibung und der Zeichnung. Ebenso können die vorstehend genannten und die weiter aufgeführten Merkmale je für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Es zeigen:
- Fig. 1: einen erfindungsgemäßen MR-Probenkopf in einem Vertikalmagneten;
- Fig. 2: einen erfindungsgemäßen MR-Probenkopf mit den wesentlichen Komponenten einer erfindungsgemäßen Kupplung zwischen Vorverstärkergehäuse und Detektionsvorrichtung;
- Fig. 3: eine detaillierte Darstellung einer erfindungsgemäßen HF-Leitungs-Kupplungsvorrichtung;
- Fig. 4: einen Ausschnitt eines erfindungsgemäßen MR-Probenkopfs mit flexibler Verbindungsleitung;
- Fig. 5: einen Temperaturverlauf einer HF-Leitung eines erfindungsgemäßen MR-Probenkopfs in Abhängigkeit ihrer laufenden Länge;
- Fig. 6: einen Temperaturverlauf einer gekühlten HF-Leitung mit Ankopplungselementen eines erfindungsgemäßen MR-Probenkopfs in Abhängigkeit ihrer laufenden Länge;
- Fig. 7: einen erfindungsgemäßen NMR-Probenkopf mit flexibler Verbindungsleitung in einem Vertikalmagneten für hochauflösende NMR-Spektroskopie;
- Fig. 8: einen erfindungsgemäßen MRI-Probenkopf mit flexibler Verbindungsleitung in einem Horizontalmagneten für MRI-Anwendungen; und
- Fig. 9: einen NMR-Probenkopf mit einer starren Verbindungseinrichtung nach dem Stand der Technik in einem Vertikalmagneten für hochauflösende NMR-Spektroskopie.

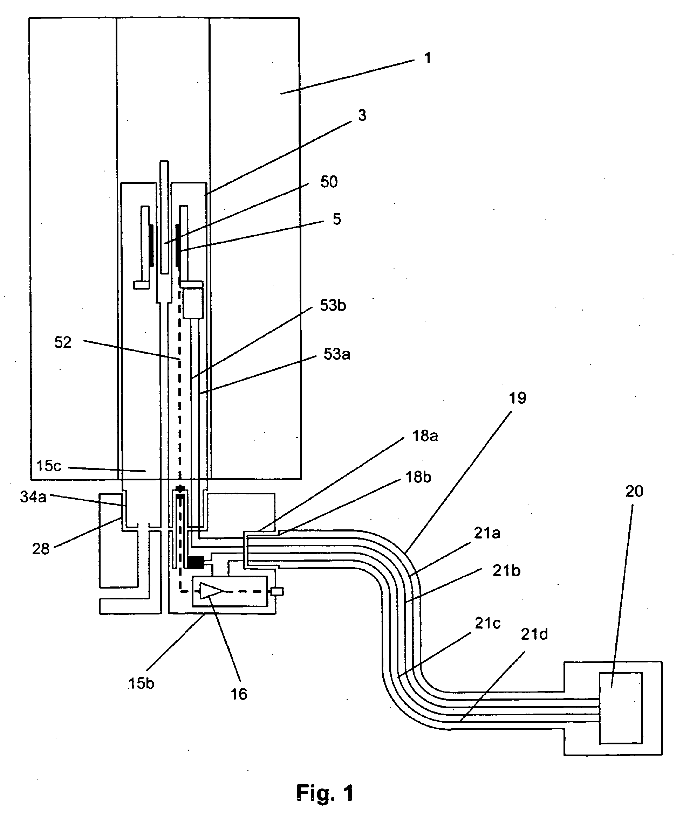

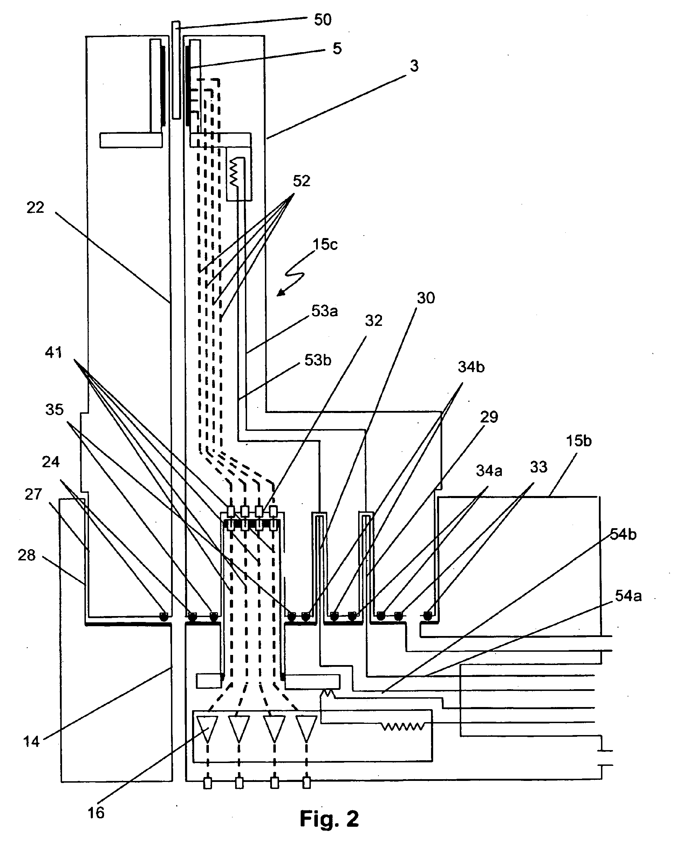

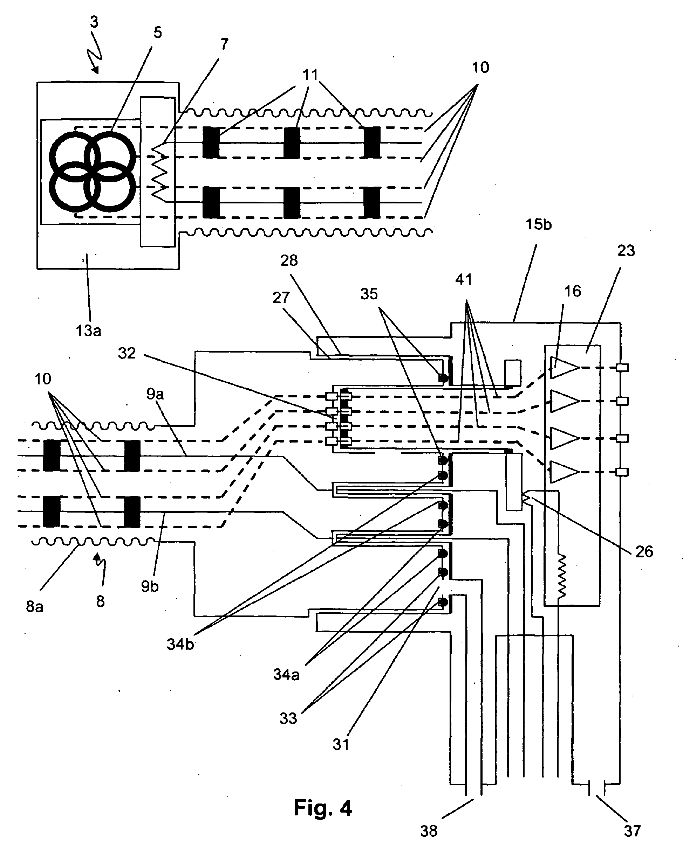

Der erfindungsgemäße Probenkopf zum Empfang von NMR-Signalen ist in **Fig. 1** (innerhalb eines Magneten **1)** und **Fig. 2** gezeigt und umfasst folgende Komponenten:
a) eine Detektionsvorrichtung **3** mit mindestens einem kryogen gekühlten Antennensystem. Das Antennensystem des erfindungsgemäßen MR-Probenkopfs umfasst mindestens eine Antenne, wobei eine solche Antenne aus mindestens einer Empfangsspule **5,** oder einem Resonator, oder einer anderen Art eines für elektromagnetische Felder empfindlichen HF-Schwingkreises bestehen kann. Um einen Wärmeübergang von einer zu vermessenden Probe **50** auf das Antennensystem zu unterbinden oder zumindest zu minimieren, ist bei dem erfindungsgemäßen MR-Probenkopf gemäß Fig. 1 und 2 ein für HF-Strahlung durchlässiges Raumtemperaturrohr **22,** beispielsweise aus Quarz, vorgesehen durch das hindurch warme Luft an der Probe 50 vorbeiströmen kann. Bei den hier behandelten Detektionsvorrichtungen 3 gemäß Fig. 1 und 2 geht es insbesondere um Systeme für die NMR-Spektroskopie oder Micro-Imaging. MRI-Systeme für die Untersuchung, insbesondere die Abbildung von Objekten, und insbesondere von Lebewesen können mit Oberflächenspulen ausgerüstet sein. Diese werden durch eine direkt oder indirekt beheizte HF-durchlässige Wand vom Messobjekt getrennt. Solche System werden typischerweise für die MRI Bildgebung verwendet und sind in den Figs. 4, 7, und 8 dargestellt.
b) einen gekühlten Vorverstärker **16** in einem separaten Vorverstärkergehäuse **15b,** das örtlich getrennt von der Detektionsvorrichtung 3 angeordnet ist,
c) eine von der Umgebung thermisch isolierte, Verbindungseinrichtung (hier eine starre Verbindungseinrichtung **15c),** mit der die Detektionsvorrichtung 3 und das Vorverstärkergehäuse 15b miteinander verbunden sind, wobei die starre Verbindungseinrichtung 15c sowohl Kühlleitungen **53a, 53b** eines ersten Kühlkreislaufs für die Zu- beziehungsweise Rückleitung eines Kühl-Fluidums, wie auch HF-Leitungen **52** zur Übertragung der elektrischen Signale umfasst.
d) eine Kupplung mit einem detektionsvorrichtungsseitigen Kupplungsteil **27** und einem vorverstärkerseitigen Kupplungsteil **28.** Die Kupplung umfasst eine HF-Leitungs-Kupplungsvorrichtung **32** (Fig. 2) sowie eine Fluid-Kupplungsvorrichtung mit Fluidkoppelementen **29, 30** (Fig. 2) zum Koppeln der Kühlleitungen 53a, 53b, die zur Detektionsvorrichtung 3 führen an vorverstärkerseitige Kühlleitungsabschnitten **54a, 54b.** Darüber hinaus verbindet die erfindungsgemäße Kupplung mittels eines O-Rings **24** das Raumtemperaturrohr 22 mit einer Raumtemperaturdurchführung **14,** die durch das Vorverstärkergehäuse 15b führt.

Die Fluid-Kupplungsvorrichtung kann entsprechend einer aus dem Stand der Technik bekannten Kupplung zwischen MR-Probenkopf und einer zu einem Kryokühler **20** führenden Transferleitung **19** mit Kupplungsteilen **18, 18b** (Fig. 1, Fig. 9) ausgeführt sein. Sie umfasst im Wesentlichen für jede der Kühlleitungen 53a, 53b jeweils ineinander greifende, typischerweise dünne Stahlröhrchen, die auf der Raumtemperaturseite mit je einem O-Ring **34a** bzw. **34b** abgedichtet sind, wie in Fig. 2 gezeigt.

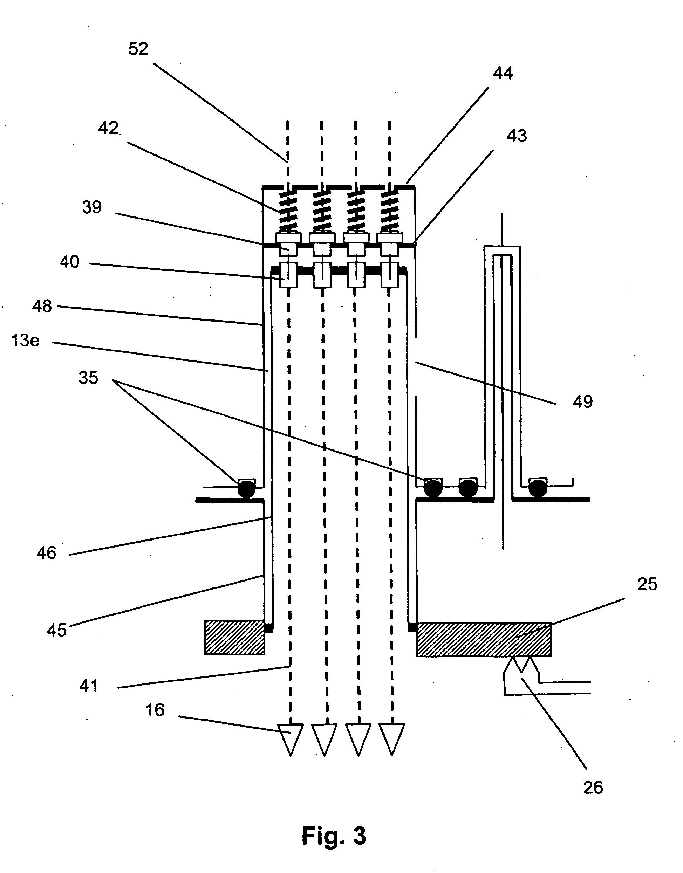

Das wesentliche Element des erfindungsgemäßen MR-Probenkopfs ist die HF-Leitungs-Kupplungsvorrichtung 32 für die HF- Leitungen 52 zwischen der Empfangsspule 5 und dem Vorverstärker 16. Die HF-Leitungen 52 sollen vorteilhafterweise im Betrieb durchgehend kalt sein. Die HF-Leitungs-Kupplungsvorrichtung 32 ist so ausgestaltet, dass eine zuverlässige und auch im kalten Betrieb sichere HF-Verbindung gewährleistet ist und umfasst die folgenden in **Fig. 3** gezeigten Elementen:
- Eine Vakuumummantelung **46** ("Ausstülpung") im Vakuummantel des Vorverstärkergehäuses ist aus einem Material mit vorteilhafterweise guter Wärmeleitfähigkeit ausgebildet (z.B. aus einem Kupferrohr).
- Vorverstärkerseitig ist die Vakuumummantelung 46 von einer weiteren Ummantelung **45** einem Material mit schlechter Wärmeleitfähigkeit ausgebildet (z.B. aus einem sehr dünnwandigen Stahlrohr), detektionsvorrichtungsseitig von einer Halterung **48** mit einer Belüftungsöffnung **49** umgeben. Die Vakuumummantelung 46 und die weiteren Ummantelung 45 sind mit einem Zwischen-Temperaturabgriff in der Form einer thermischen Stufe **25,** der mit einem kleinen Wärmetauscher **26** verbunden ist, getrennt. Die Funktion dieser Anordnung wird später noch genauer beschrieben.
- Am Ende der Vakuumummantelung 46 befinden sich HF-Buchsen **40.** Die HF-Buchsen 40 sind vorteilhafterweise vakuumdicht ausgeführt, entweder direkt oder durch eine vorgelagerte Vakuumdurchführung. Sie sind jeweils mit einer weiterführenden HF-Leitung **41** mit den Vorverstärkern 16 verbunden. Darüber hinaus sind die HF-Buchsen 40 vorzugsweise so ausgeführt, dass sie ohne ein Schrauben oder Verdrehen direkt linear mit einem passenden detektionsvorrichtungsseitigen HF-Stecker **39** kuppelbar sind.
- Die detektionsvorrichtungsseitigen HF-Stecker 39 sind vorteilhafterweise in einer Führung **43** längs verschiebbar geführt und gemeinsam oder noch besser einzeln mit Federelementen **42** (Druckfedern) ausgerüstet, die sich mechanisch z.B. auf einer Gegenplatte **44** abstützen. Diese Ausführung gewährleistet auch bei etwaigen Dimensionsänderungen, die sich aus der Abkühlung insbesondere der Strukturteile 45, 46, 48 ergeben können, stets eine vollkommene Anpressung und somit eine einwandfreie HF-Übetragung. Die HF-Stecker 39 können direkt an die HF-Leitungen 52 angeschlossen sein, die zu den Empfangsspulen 5 gehen.

**Fig. 4** zeigt eine besonders vorteilhafte Ausführungsform des erfindungsgemäßen MR-Probenkopfs, mit einer flexiblen Verbindungsleitung **8** als Verbindungseinrichtung, über welche die Detektionsvorrichtung 3 und das Vorverstärkergehäuse 15b miteinander verbunden sind. Die gezeigte Verbindungsleitung 8 umfasst einen vakuumdichten Außenmantel, hier in Form eines Wellbalgs **8a,** zwei flexible Kühlleitungen **9a, 9b,** sowie flexible HF-Leitungen **10** und ist gestreckt dargestellt, wobei im oberen Teil der Figur die Fortsetzung der Leitungen 52 gezeigt ist. Die weiterführende HF-Leitung 41 zwischen HF-Leitungskupplungsvorrichtung 32 und Vorverstärker 16 muss jedoch nicht flexibel sein. Die Leitungen 9a, 9b, 10 sind mittels Ankopplungselementen **11** thermisch aneinander gekoppelt. Ein solches Ankopplungselement 11 besteht typischerweise aus einem Cu-Zylinder, an dem die Kühlleitung 9a, 9b, die flexiblen HF-Leitung 10, sowie ggf. weitere Elemente mechanisch und thermisch verbunden sind, vorteilhafterweise durch Löten. Die Empfangsspulen 5 bilden hier ein 4-er Spulen-Array und werden durch einen Wärmetauscher **7** gekühlt. Jede der in Fig. 4 gezeigten vier Empfangsspulen 5 ist mittels einer der flexiblen HF-Leitungen 10 mit einem der gekühlten Vorverstärker 16 verbunden. Die vier Vorverstärker 16 können in diesem Ausführungsbeispiel mit einer thermischen Stufe (Wärmesenke) **23** innerhalb eines zweiten Kühlkreislaufs, wie in [6] beschrieben, mit weiterführenden Kühlleitungen **21c, 21d** des kryokühlerseitigen Kupplungsteils 18b (Fig. 1) verbunden werden.

Bei der in Fig. 4 gezeigten Ausführungsform umfasst die erfindungsgemäße Kupplung darüber hinaus auch einen automatischen Vakuumanschluss **31** mit einem O-Ring **33.** Der Vakuumanschluss 31 kann direkt ins Vakuum des Vorverstärkergehäuses 15b führen, oder aber vorteilhafterweise zu einer getrennten Vakuumleitung **38.** Diese kann mit einer Pumpvorrichtung auf eine kontrollierte Weise abwechslungsweise oder auch gleichzeitig mit einem Vakuum-Pumpanschluss **37** des Vorverstärkergehäuses gepumpt werden.

Um sicher zu stellen, dass auch der Zwischenraum **13e** (Fig. 3) der HF-Leitungs-Kupplungsvorrichtung 32 ausgepumpt werden kann, befindet sich um den detektionsvorrichtungsseitige Kupplungsteil 27 herum eine Vakuumdichtung **35.** Durch diese wird es auch überflüssig, die HF-Stecker 39 auf der Empfangsspulenseite vakuumdicht zu gestalten. Auch die die Ausstülpung (Vakuumummantelung 46) umgebende weitere Ummantelung 45 bzw. die Halterung 48 muss empfangsspulenseitig kein geschlossener Mantel sein, sondern kann nur eine die Druckkräfte der HF-Stecker 39 übertragende Struktur sein.

In einer alternativen, nicht gezeigten Ausführungsform, ist es aber auch möglich, die gesamte Detektionsvorrichtung 3 inkl. Verbindungsleitung 8 beziehungsweise Verbindungseinrichtung 15c mit einem Permanentvakuum auszustatten. In diesem Fall muss die Halterung 48 als ein geschlossener Mantel ausgebildet sein, und die Belüftungsöffnung 49 entfällt. Dann müssen auch die HF-Stecker 39 vakuumdicht ausgeführt werden. Der Vakuumanschluss 31 und die Vakuumleitung 38 sowie die Notwendigkeit, die Detektionsvorrichtung 3 nach dem Ankoppeln und vor dem Abkühlen zu pumpen entfallen. Dafür kondensiert dann beim Abkühlen Luft in dem Zwischenraum 13e (Fig. 3), was aber nicht weiter problematisch ist.

Die gesamte erfindungsgemäße Kupplung wird mit einem Andruckelement (nicht dargestellt) mit der erforderlichen Kraft an das Vorverstärkergehäuse 15b angedrückt und in der angedrückten Position gehalten. Die Anpresskraft muss hinreichend groß sein, um einerseits alle O-Ringe 24, 33, 34a, 34b, 35 dichtend anzupressen, und auch alle HF-Verbindungen der HF-Leitungskupplungsvorrichtung 32 korrekt zu positionieren. Dieses Andruckelement kann typischerweise aus einer Überwurfmutter bestehen, oder aber mit Schnallen, Exzenter oder ähnlichen Bauelementen implementiert sein.

Die oben aufgeführten Merkmale können von den in den Figuren beschriebenen Beispielen abweichen, indem bspw. verschiedene Topologien, Spiegelungen, Vertauschen der Anordnung der beiden Seiten der Kupplung etc. vorgesehen sind.

### Betrieb des erfindungsgemäßen MR-Probenkopfs:

Die Ausgangslage sei ein warmes System. Dabei ist noch kein Messeinsatz, (umfassend Detektionsvorrichtung 3, flexible Verbindungsleitung 8 beziehungsweise starre Verbindungseinrichtung 15c und detektionsvorrichtungsseitiger Kupplung 27) montiert. Normalerweise ist in diesem Zustand das Vorverstärkergehäuse 15b bereits evakuiert, denn bei dem hier beschriebenen Aufbau besteht kein Grund, dieses Vakuum bei der Abkopplung der zuvor verwendeten Detektionsvorrichtung 3 zu brechen.

Nun wird der gewünschte Messeinsatz gewählt. Er befindet sich auf Zimmertemperatur und ist normalerweise nicht evakuiert. Sein detektionsvorrichtungsseitiges Kupplungsteil 27 wird in das vorverstärkerseitige Kupplungsteil 28 im Vorverstärkergehäuse 15b eingeführt und durch das Andruckelement in die korrekte Position angedrückt. Dadurch dichten alle O-Ringe 24, 33, 34a, 34b, 35, und die HF-Stecker 39 werden schlüssig angepresst.

Als Vorbereitung zum Abkühlen wird zunächst der Messeinsatz evakuiert. Dies geschieht durch den Anschluss der Vakuumleitung 38 an ein Vakuumpumpsystem, das bei einem solchen System normalerweise bereits vorhanden ist. Unterdessen werden die Kühlleitungen 9a, 9b, 53a, 53b und die weiterführenden Kühlleitungen 21 a, 21 b, 21 c, 21 d durch mehrmaliges Spülen mit reinem Helium gereinigt. Dies ist bei solchen Geräten stets nötig, um ein Einfrieren und Blockieren der Leitungen durch ein Gefrieren der Luft oder Feuchtigkeit zu verhindern. Dies ist, falls der Vorverstärkerteil nicht gewechselt worden ist, im Prinzip nur für die Kühlleitungen 9a, 9b, 53a, 53b sowie für die beiden weiterführenden Kühlleitungen 21 a, 21 b der Empfangsspulenkühlung nötig.

Danach wird der Kühlkopf des Kryokühlers 20 in Betrieb gesetzt, und die Zirkulation in den Kühlleitungen 9a, 9b, 53a, 53b, 21 a, 21 b wird gestartet. Dadurch wird der Vorverstärker 16 wie auch die Empfangsspulen 5 auf die jeweilig vorgesehene Betriebstemperatur abgekühlt. Typischerweise ist das z.B. 77 K für den Vorverstärker 16 und 20 K für die Empfangsspulen 5. Vorzugsweise werden auch die HF-Leitungen 10, und ggf. 52 auf praktisch ihrer gesamten Länge auf Temperaturen nahe bei 20 K abgekühlt.

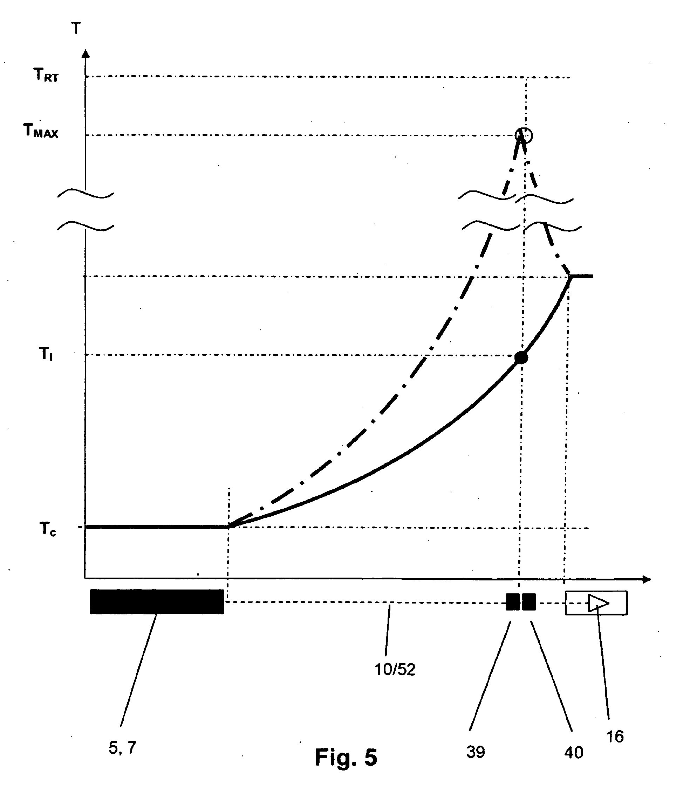

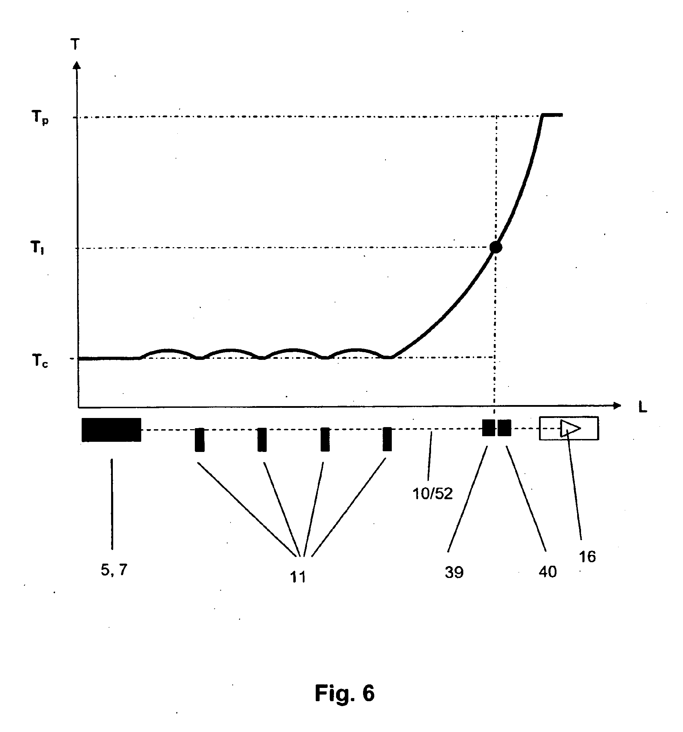

Es ist nun wünschenswert, dass einerseits die HF-Leitungen 10, 52 nirgends unnötig warm werden (d.h. sicher nicht über die Betriebstemperatur des Vorverstärkers, hier 77K). Andererseits sollen auch keine unnötigen Wärmeeinträge auf der Seite der Kühlleitungen 9a, 9b, 53a, 53b, 21 a, 21 b entstehen. Dies wird durch die erfindungsgemäßen Ausführung der Kupplung wie folgt gewährleistet. Die Temperatur der HF-Leitungen 10, 52 ist in **Fig. 5** und **Fig. 6** als Funktion der Längskoordinate (Position) **L** entlang der flexiblen Verbindungsleitung 8 beziehungsweise entlang der starren Verbindungseinrichtung 15c dargestellt: Im Bereich der Empfangsspulen 5 und des Wärmetauschers 7 befindet sie sich etwa auf der Temperatur **T_{c}** der Empfangsspulen 5. Die HF-Stecker 39 und die HF-Buchsen 40 werden auf eine möglichst tiefe Temperatur **T**ₗ abgekühlt, ohne jedoch den ersten Kühlkreislauf zu belasten. Diese Abkühlung findet auf eine Temperatur statt, die unter der Temperatur **Tₚ** des Vorverstärkers 16 liegt (durchgezogene Linie). Die Abkühlung erfolgt vorzugsweise durch den Wärmetauscher 26 (Fig. 4), wobei dieser in der Vorwärtsleitung der Vorverstärker-Kühlleitung, die über die weiterführende Kühlleitung 21 c geht, angeordnet ist. Dies hat zur Folge, dass das He dort auf einer Temperatur unter der Vorverstärkertemperatur Tₚ von z.B. 77K ist, d.h. z.B. 50K. (Nur das aus dem Vorverstärker 16 austretende He hat eine Temperatur von ca. 77K, das in den Vorverstärker 16 eintretende He muss eine tiefere Temperatur aufweisen, um die Kühlung überhaupt zu ermöglichen, d.h. die im Vorverstärker 16 anfallende Wärmeleistung aufnehmen und abtransportieren zu können). Dies hat zur Folge, dass die thermische Stufe 25 und somit der Vakuumummantelung 46 der HF-Leitungskupplungsvorrichtung 32 nun auf ungefähr diese 50K abgekühlt wird. Dabei wird dann der thermische Gradient zwischen Raumtemperatur und den 50K von der weiteren Ummantelung 45 aufgenommen. Durch die Kühlung erreichen im Idealfall auch die HF-Stecker 39 und die HF-Buchsen 40 die Temperatur **T**ₗ in dieser Größenordnung, auf jeden Fall werden sie nicht über die Vorverstärkertemperatur **T**ₚ erwärmt, was sonst wegen der Wärmeleitung entlang der Vakuumummantelung 46 der Fall sein könnte. Dadurch wird der allmähliche Abfall der Temperatur von 77 auf 20 K nicht gestört.

Fig. 6 zeigt den Temperaturverlauf einer HF-Leitung 10, ggf. 52 mit Ankopplungselementen 11. Die Kühlung der HF-Leitung 10, und ggf. 52 wird durch die mehr oder weniger regelmäßige thermische Anbindung der HF-Leitung 10, und ggf. 52 durch die Ankopplungselemente 11 auf der gesamten Länge zwischen den Ankopplungselementen 11 aufrechterhalten. Diese befinden sich etwa auf der Temperatur **T_{c}** der Empfangsspulen 5oder etwas darunter, da sie direkt von der oder den Kühlleitungen 9a, 9b, und ggf. 53a, 53b gekühlt werden. Der Vorlauf 9a hat dabei stets eine tiefere Temperatur als die Empfangsspule 5. Der Temperaturverlauf der HF-Leitungen 10, und ggf. 52 zwischen den Ankopplungselementen 11 ist annähernd eine quadratische Funktion. Dadurch kann die maximale Temperaturüberhöhung im Bedarfsfall durch eine etwas engere Anordnung der Ankopplungselemente 11 schnell reduziert werden. Erst auf einer genau zu wählenden Strecke kurz vor dem Vorverstärker 16 hören die thermischen Anbindungen mit den Ankopplungselementen 11 auf. Dann ergibt sich ein kontinuierlicher Übergang zwischen der Temperatur der Kühlleitung 9a, 9b, 53a, 53b und der Vorverstärkertemperatur Tₚ. Der genaue Verlauf hängt von der Wärmeleitfähigkeit der HF-Leitung 10, und ggf. 52 als Funktion der Temperatur sowie vom externen Wärmeeintrag ab und ist nur schematisch dargestellt. Die Länge der Strecke dieses Übergangs wird aber so dimensioniert, dass die totalen zusätzlichen HF-Verluste bzw. der Rauscheintrag des wärmeren Teils der HF-Leitung 10, und ggf. 52 so gering wie möglich werden, ohne aber eine zu hohe Wärmebrücke zwischen den Kühlleitungen 9a, 9b, und ggf. 53a, 53b und dem Vorverstärkern 16 zu bilden. Durch die beschriebene Kühlung ist es bei geeigneter Wahl der Geometrien sogar möglich, dass die mittlere Temperatur des HF- Kabels im Bereich zwischen dem verstärkerseitig letzten der Ankopplungselemente 11 und dem Vorverstärker 16 abgesenkt wird.

Alternativ kann der Wärmetauscher 26 auch direkt an der Endplatte der HF-Kupplung angebracht werden (nicht dargestellt). Dann werden die HF-Buchsen 40 direkt und sehr effizient gekühlt.

Ohne diese Zwischenkühlung der Vakuumummantelung 46 oder der HF-Stecker 39 und HF-Buchsen 40 würde eine direkte thermische Verbindung zwischen der Umgebung (Raumtemperatur **T_{RT}**) und den HF-Leitungen 10, 52 entstehen und die Temperatur der HF-Leitung 10, 52 würde den Verlauf der in Fig. 5 stellvertretend gezeigten gestrichpunkteten Linie aufweisen. Dies würde die HF-Leitung 10, 52 auf eine viel zu hohe Temperatur **T_{MAX}** bringen, was eine unnötige Verschlechterung der S/N-Eigenschaften und gleichzeitig auch einen unzulässigen Wärmeeintrag in diese und somit in den ersten Kühlkreislauf bewirkt.

Nach Beendigung der Messungen wird zum Auswechseln des Messeinsatzes wie folgt vorgegangen: Das System wird durch Zirkulation von warmem He-Gas und eventuell noch mit einzelnen elektrischen Heizern zunächst aufgewärmt. Dann wird das Vakuum des Messeinsatzes gebrochen und der Messeinsatz wird entfernt. Nun kann dieser durch einen anderen ersetzt werden, und ein erneutes Abkühlen kann stattfinden. Im Falle einer flexiblen Verbindungsleitung 8 können diese Abkühl- und Aufwärmphasen stattfinden, während sich der erfindungsgemäße MR-Probenkopf außerhalb des Magneten 1 befindet. In dieser Zeit kann der Magnet 1 für andere Messungen verwendet werden.

Die oben beschriebene Kupplung ist sehr einfach zu bedienen, und durch eine Automatisierung der Pump-, Abkühl- sowie Aufwärmvorgänge, zusammen mit dem automatischen Anschluss aller Leitungen und Anschlüsse, ist ein sehr einfacher, problemloser und auch für nicht spezialisiertes Personal einfach durchzuführender Betrieb möglich.

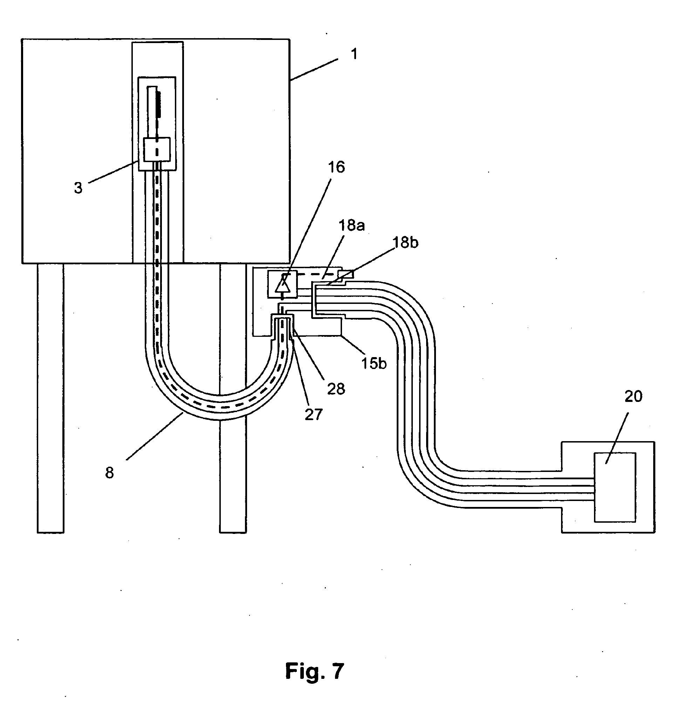

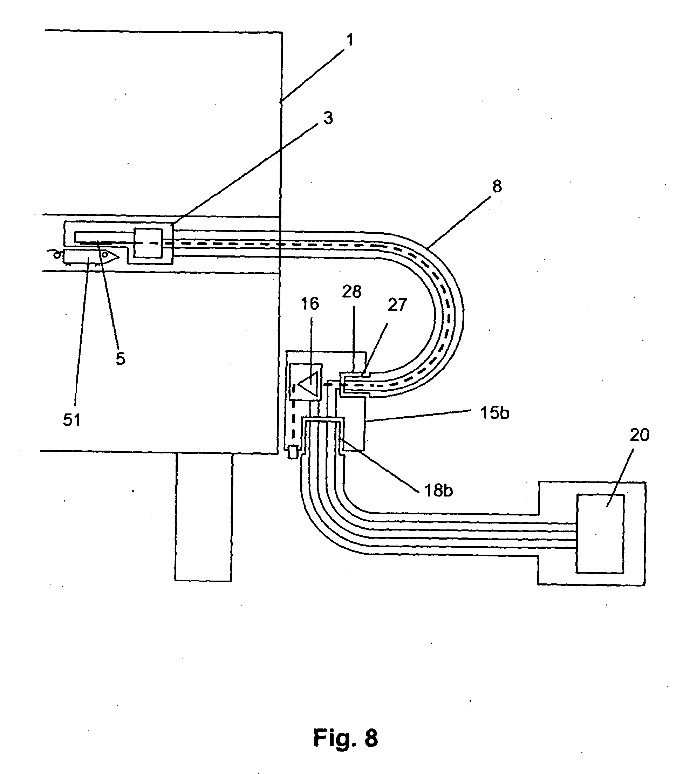

Abschließend zeigen **Fig. 7** und **Fig. 8** zwei mögliche MR-Systemkonfigurationen. In Fig. 7 ist ein NMR-System für hochauflösende NMR-Spektroskopie oder Micro-Imaging, in Fig. 8 ein MRI-System für MR-Bildgebung dargestellt.

Das Vorverstärkergehäuse 15b ist hier am Magneten 1 befestigt, und über eine Kupplung mit Kupplungsteilen 18a, 18b nach Stand der Technik mit dem Kryokühler 20 verbunden. Der Vorverstärker 16 kann z.B. vier 1 H Vorverstärker beinhalten, und/ oder aber auch verschiedene schmal- oder auch breitbandige Verstärker für Kerne wie z.B. 31 P, 13C, 15N, 23Na, 19F, 2H etc. aufweisen. In das Vorverstärkergehäuse 15b ist ein Messeinsatz, umfassend die Detektionsvorrichtung 3, die flexibler Verbindungsleitung 8, sowie die erfindungsgemäße Kupplung mit den Kupplungsteilen 27, 28, eingesteckt, der mittels der flexiblen Verbindungsleitung 8 in den Magneten 1 hineingeht und dort mit der Detektionsvorrichtung 3 endet. Dieses misst nun mittels der gekühlten Empfangsspule 5 MR-Signale eines Messobjekts **51**. Die Messeinsätze sind mehrfach vorhanden und können in diesem Beispiel nun mit verschiedensten Spulenanordnungen zwischen 1 und 4 Spulen ausgestattet sein, und hier mittels der Kupplungsteile 18a, 18b nach Belieben gewechselt werden. Sollte eines Tages der Vorverstärker 16 nicht alle Ansprüche erfüllen, kann er durch eine andere Variante ersetzt oder ergänzt werden, die z.B. andere Kerne wie 31 P oder 23Na beinhaltet.

Der Messeinsatz kann für die verschiedensten Anwendungen, von MR-Bildgebung bis zu spektroskopischen Hochauflösungsanwendungen ausgebildet sein, jederzeit aus dem Magneten 1 herausgenommen und gegen andere Einsätze getauscht werden. Somit entsteht ein äußert einfach zu handhabendes und universell einsetzbares System.

Es sind noch weitere Variationen und Ausführungsformen des beschriebenen Systems möglich. Obwohl es der Platzbedarf wie auch die geringste Komplexität wie auch beste Leistungsfähigkeit (niedrigste erreichbare Temperaturen) ratsam erscheinen lassen, die erfindungsgemäße Kupplung mit ihren Kupplungsteilen 27, 28 am vorverstärkerseitigen Ende der flexiblen Verbindungsleitung 8 beziehungsweise der starren Verbindungseinrichtung 15c zu platzieren, muss die Kupplung nicht zwingend dort angeordnet sein, sondern kann auch auf der Seite der Detektionsvorrichtung 3 oder aber auch irgendwo dazwischen platziert werden. Im ersteren Falle müsste insbesondere die Verbindungsleitung 8 beziehungsweise der Verbindungseinrichtung 15c nur einmal zusammen mit dem Vorverstärkergehäuse 15b erworben werden, und der Messeinsatz würden dann nur noch aus der Detektionsvorrichtung 3 und dem Kupplungsteil 27 bestehen und wären dann um einiges kompakter.

Der erfindungsgemäße MR-Probenkopf realisiert sowohl eine gute Performance als auch eine einfache Handhabung, denn die Detektionsvorrichtung 3, also das Ende des MR-Probenkopfs, ist klein, leicht, und lässt sich dank der erfindungsgemäßen Kopplung leicht austauschen. Zudem können die Kosten für Austauscheinsätze verringert werden.

### 5. Bezugzeichenliste

- 1: Magnet
- 2: Raumtemperaturbohrung des Magneten
- 3: Detektionsvorrichtung
- 5.: Empfangsspule
- 7.: Wärmetauscher zur Kühlung der Empfangsspule
- 8.: flexible Verbindungsleitung zwischen Detektionsvorrichtung und Vorverstärker
- 8a: Wellbalg
- 9a.: flexible Kühlleitung für Spulenkühlung (Vorlauf)
- 9b.: flexible Kühlleitung für Spulenkühlung (Rücklauf)
- 10.: flexible HF-Leitung
- 11.: Ankopplungselement zwischen Kühlleitung und HF-Leitung
- 13e.: Zwischenraum der HF-Leitungs-Kupplungsvorrichtung (vorzw. evakuiert)
- 15a.: Vorverstärkergehäuse als Teil des Probenkopfs
- 15b.: separates Vorverstärkergehäuse
- 15c.: starre Verbindungseinrichtung zwischen Detektionsvorrichtung und Vorverstärkergehäuse
- 16.: gekühlter Vorverstärker
- 17.: Signalausgang am Ausgang des Vorverstärkers
- 18a.: vorverstärkerseitiges Kupplungsteil zwischen Vorverstärkergehäuse und Kryokühler
- 18b.: kryokühlerseitiges Kupplungsteil zwischen Vorverstärkergehäuse und Kryokühler
- 19.: Transferleitung zwischen Kryokühler und Probenkopf
- 20.: Kryokühler
- 21a: weiterführende Kühlleitung
- 21b: weiterführende Kühlleitung
- 21c: weiterführende Kühlleitung
- 21d: weiterführende Kühlleitung
- 22: Raumtemperaturrohr
- 23.: thermische Stufe (Wärmesenke) des oder der gekühlten Vorverstärker
- 24.: O-Ring zwischen Raumtemperaturrohr und Raumtemperaturdurchführung
- 25.: thermische Stufe zur Zwischenkühlung der Ummantelung der HF-Kupplung
- 26.: Wärmetauscher zur Zwischenkühlung der Ummantelung der HF-Kupplung
- 27.: detektionsvorrichtungsseitiges Kupplungsteil zwischen Detektionsvorrichtung und Vorverstärkergehäuse
- 28.: vorverstärkerseitiges Kupplungsteil zwischen Detektionsvorrichtung und Vorverstärkergehäuse,
- 29.: Fluidkoppelelement der Fluidkupplungsvorrichtung zwischen Detektionsvorrichtung und Vorverstärkergehäuse (Vorlauf)
- 30.: Fluidkoppelelement der Fluidkupplungsvorrichtung zwischen Detektionsvorrichtung und Vorverstärkergehäuse (Rücklauf)
- 31.: Vakuumanschluss für Detektionsvorrichtung
- 32: HF-Leitungskupplungsvorrichtung
- 33.: O-Ring zur Abdichtung des Vakuumanschlusses
- 34a.: O-Ring zur Abdichtung des Vorlaufs der Fluidkupplungsvorrichtung
- 34b.: O-Ring zur Abdichtung des Rücklaufs Fluidkupplungsvorrichtung
- 35.: O-Ring zur Abdichtung der HF-Leitungskupplungsvorrichtung
- 37.: Vakuum-Pumpanschluss für Vorverstärkergehäuse
- 38.: Vakuumleitung für Detektionsvorrichtung
- 39.: HF-Stecker an der Detektionsvorrichtung (verschiebbar)
- 40.: HF-Buchse
- 41.: weiterführende HF-Leitung zwischen HF-Leitungskupplungsvorrichtung und Vorverstärker
- 42.: Federelement für HF-Stecker
- 43.: Führungsteil für HF-Stecker
- 44.: Gegenplatte für Kraftaufnahme
- 45.: weitere Ummantelung der HF-Kupplung
- 46.: Vakuumummantelung der HF-Leitungskupplungsvorrichtung
- 48.: Halterung des Steckerteils
- 49.: Belüftungsöffnung in der Halterung des HF-Steckers
- 50.: Messprobe
- 51.: Messobjekt
- 52.: starre HF-Leitung innerhalb Probenkopf
- 53a.: starre Kühlleitung innerhalb Probenkopf (Vorlauf)
- 53b.: starre Kühlleitung innerhalb Probenkopf (Rücklauf)
- 54a.: vorverstärkerseitiger Kühlleitungsabschnitt (Vorlauf)
- 54b.: vorverstärkerseitiger Kühlleitungsabschnitt (Rücklauf)
- Tₚ: Temperatur des Vorverstärkers
- T_{c}: Temperatur der Empfangsspule
- T_{RT}: Raumtemperatur
- Tₗ: Interface-Temperatur der HF-Leitung am Punkt der HF-Stecker
- L: aufende Länge entlang der HF-Leitung (Koordinate)

### 6. Referenzliste

[1] WO 2003/050554 A3
[2] DE 196 48 253 A1
[3] DE 199 46 371 C1
[4] "Cryogenic probe setup for routine MR imaging on small animals at 9.4 T", R. Haueisen. D. Marek, M. Sacher, F. Kong, K. Ugurbil, S. Junge, ESMRM Basel, 16. Sept. 2005.
[5] US 5,829,791
[6] US 5,889,456

## Patentansprüche

1. Magnetresonanz(=MR)-Probenkopf
mit einer Detektionsvorrichtung (3) mit mindestens einem von einer Kühlvorrichtung kryogen gekühlten Antennensystem
sowie mit einem gekühlten Vorverstärker (16) in einem Vorverstärkergehäuse (15a, 15b), welches örtlich getrennt von der Detektionsvorrichtung (3) angeordnet ist, und
mit einer thermisch isolierenden Verbindungseinrichtung, über die die Detektionsvorrichtung (3) und das Vorverstärkergehäuse (15a, 15b) miteinander verbunden sind, wobei die Verbindungseinrichtung mindestens eine Kühlleitung (9a, 9b, 53a, 53b) für die Zu- und/oder Rückleitung eines Kühl-Fluids, sowie mindestens eine HF-Leitung (10, 52) zur Übertragung der elektrischen Signale umfasst,
**dadurch gekennzeichnet,**
**dass** die Verbindungseinrichtung, inklusive ihrer HF- und Kühlleitungen (10, 52, 9a, 9b, 53a, 53b) mittels einer Kupplung vom Vorverstärkergehäuse (15a, 15b) abtrennbar ist.

2. MR-Probenkopf nach Anspruch 1, **dadurch gekennzeichnet, dass** es sich um einen Probenkopf für Magnetresonanz-Bildgebung(=MRI) - Anwendungen oder für NMR(Kernspinresonanz)-Spektroskopie handelt.

3. MR-Probenkopf nach einem der Ansprüche 1 oder 2, **dadurch gekennzeichnet, dass** mindestens zwei Kühlleitungen (9a, 9b, 53a, 53b) vorgesehen sind, die Teil eines ersten Kühlkreislaufs sind.

4. MR-Probenkopf nach einem der vorhergehenden Ansprüche, **dadurch gekennzeichnet, dass** die Kupplung eine Fluid-Kupplungsvorrichtung mit Fluidkoppelelementen (29, 30) zum Koppeln der mindestens einen Kühlleitung (9a, 9b, 53a, 53b), die zur Detektionsvorrichtung (3) führt, an mindestens einen vorverstärkergehäuseseitigen Kühlleitungsabschnitt (54a, 54b), sowie eine HF-Leitungs-Kupplungsvorrichtung (32) aufweist, wobei die HF-Leitungs-Kupplungsvorrichtung (32) mindestens ein erstes HF-Leitungskoppelelement, insbesondere einen antennensystemseitigen HF-Stecker (39), und mindestens ein zweites HF-Leitungskoppelelement, insbesondere eine HF-Buchse (40), zur Ankopplung der HF-Leitungen (10, 52) zum Signaleingang des Vorverstärkers (16), umfasst.

5. MR-Probenkopf nach Anspruch 4, **dadurch gekennzeichnet, dass** für mindestens ein Paar von ersten und zweiten HF-Koppelelementen (39, 40) ein Federelement (42) vorgesehen ist, welches das erste HF-Koppelelement und das zugehörige zweite HF-Koppelelement gegeneinander drückt.

6. MR-Probenkopf nach einem der Ansprüche 4 oder 5, **dadurch gekennzeichnet, dass** die HF-Koppelelemente und/oder eine Vakuumummantelung (46), welche die ersten HF-Koppelelemente umgibt, mit einer thermischen Stufe (25) gekühlt werden.

7. MR-Probenkopf nach Anspruch 6, **dadurch gekennzeichnet, dass** die thermische Stufe (25) der HF-Leitungskoppelelemente (39, 40) mit einem Wärmetauscher (24) des Vorverstärkers (16), einer thermischen Stufe (23) des Vorverstärkers oder dem Vorverstärker (16) selbst thermisch verbunden ist.

8. MR-Probenkopf nach einem der Ansprüche 3 bis 7, **dadurch gekennzeichnet, dass** die Elektronik des gekühlten Vorverstärkers (16) durch einen von der mindestens einen Kühlleitung (9a, 9b, 53a, 53b) separaten, zweiten Kühlkreislauf gekühlt wird, wobei der erste und der zweite Kühlkreislauf von derselben Kühlvorrichtung gekühlt werden.

9. MR-Probenkopf nach einem der Ansprüche 6 bis 8, **dadurch gekennzeichnet, dass** zur Kühlung der thermischen Stufe (25) der HF-Leitungskoppelelemente ein Wärmetauscher (26) vorgesehen ist, der in der Vorlaufleitung des zweiten Kühlkreislaufs oder durch die Rücklaufleitung des ersten Kreislaufs angeordnet ist.

10. MR-Probenkopf nach einem der Ansprüche 6 bis 9, **dadurch gekennzeichnet, dass** die thermische Stufe (23) im Betrieb eine Temperatur unterhalb der Vorverstärkertemperatur aufweist.

11. MR-Probenkopf nach einem der vorhergehenden Ansprüche, **dadurch gekennzeichnet, dass** die Kupplung einen Vakuumanschluss (38) zur Ankopplung an eine Vakuumleitung (38) umfasst.

12. MR-Probenkopf nach einem der vorhergehenden Ansprüche, **dadurch gekennzeichnet, dass** die Verbindungseinrichtung als eine mechanisch flexible Verbindungsleitung (8) mit mechanisch flexiblen HF- und Kühlleitungen (9a, 9b, 10) ausgeführt ist.

13. MR-Probenkopf nach einem der vorhergehenden Ansprüche, **dadurch gekennzeichnet, dass** jeweils eine oder mehrere HF-Leitungen (10, 52) einer einzelnen Kühlleitung (9a, 9b, 53a, 53b) zugeteilt sind und dort zusammen mit der zugeteilten Kühlleitung (9a, 9b, 53a, 53b) jeweils ein Leitungspaket bilden, und dass die der Kühlleitung (9a, 9b, 53a, 53b) zugeteilten HF-Leitungen (10, 52) eines einzelnen Leitungspaketes in, vorzugsweise regelmässigen, Abständen über thermisch gut leitende Ankopplungselemente (11) miteinander thermisch verbunden sind.

14. MR-Probenkopf nach einem der Ansprüche 12 bis 13, **dadurch gekennzeichnet, dass** die kalten Teile der Verbindungsleitung (8), insbesondere die Kühlleitungen (9a, 9b) sowie die HF-Leitungen (10), zur thermischen Isolation in einem Vakuum innerhalb mindestens eines flexiblen Außenmantel angeordnet sind.

15. MR-Probenkopf nach einem der vorhergehenden Ansprüche, **dadurch gekennzeichnet, dass** das Antennensystem bei einer tieferen Temperatur betrieben wird als der Vorverstärker (16).

16. MR-Probenkopf nach einem der Ansprüche2 bis 15, **dadurch gekennzeichnet, dass** der Vorverstärker (16) mehrere parallele Vorverstärkerkanäle umfasst, insbesondere 2, 3, 4, 6, 8,12, oder 16 parallele Kanäle für den gleichen zu untersuchenden Kern, insbesondere 1 H.

17. MR-Probenkopf nach einem der Ansprüche 2 bis 16, **dadurch gekennzeichnet, dass** der Vorverstärker (16) Kanäle für die Verstärkung der Signale der Kerne 31 P, 13C, 23Na, 19F, 170, 129Xe oder 2H umfasst.

18. MR-System mit einem MR-Probenkopf nach einem der vorhergehenden Ansprüche.

19. MR-System nach Anspruch 18, **dadurch gekennzeichnet, dass** es sich um ein MRI- oder ein NMR-System handelt.

## Claims

1. Magnetic resonance (MR) probe head comprising a detecting device (3) with at least one antenna system which is cryogenically cooled by a cooling device, and a cooled preamplifier (16) in a preamplifier housing (15a, 15b) which is spatially separated from the detecting device (3), and a thermally insulating connecting means via which the detecting device (3) and the preamplifier housing (15a, 15b) are connected, wherein the connecting means comprises at least one cooling line (9a, 9b, 53a, 53b) for supplying and/or returning a cooling fluid, and at least one RF line (10, 52) for transmitting the electric signals,
**characterized in that**
the connecting means including its RF and cooling lines (10, 52, 9a, 9b, 53a, 53b) can be separated from the preamplifier housing (15a, 15b) by a coupling.

2. MR probe head according to claim 1, **characterized in that** it is a probe head for magnetic resonance imaging (MRI) applications or for NMR (nuclear magnetic resonance) spectroscopy.

3. MR probe head according to one of the claims 1 or 2, **characterized in that** at least two cooling lines (9a, 9b, 53a, 53b) are provided which are part of a first cooling circuit.

4. MR probe head according to any one of the preceding claims, **characterized in that** the coupling comprises a fluid coupling device with fluid coupling elements (29, 30) for coupling the at least one cooling line (9a, 9b, 53a, 53b) leading to the detecting device (3), to at least one cooling line section (54a, 54b) on the side of the preamplifier housing, and an RF line coupling device (32), wherein the RF line coupling device (32) comprises at least one first RF line coupling element, in particular, an RF plug (39) on the antenna system side, and at least one second RF line coupling element, in particular, an RF socket (40) for coupling the RF lines (10, 52) to the signal input of the preamplifier (16).

5. MR probe head according to claim 4, **characterized in that** a spring element (42) is provided for at least one pair of first and second RF coupling elements (39, 40), which bears the first RF coupling element and the associated second RF coupling element against each other.

6. MR probe head according to one of the claims 4 or 5, **characterized in that** the RF coupling elements and/or a vacuum jacket (46) which surrounds the first RF coupling elements, are cooled with a thermal stage (25).

7. MR probe head according to claim 6, **characterized in that** the thermal stage (25) of the RF line coupling elements (39, 40) are thermally connected to a heat exchanger (24) of the preamplifier (16), a thermal stage (23) of the preamplifier, or the preamplifier (16) itself.

8. MR probe head according to any one of the claims 3 through 7, **characterized in that** the electronics of the cooled preamplifier (16) is cooled by a second cooling circuit which is separate from the at least one cooling line (9a, 9b, 53a, 53b), wherein the first and the second cooling circuit are cooled by the same cooling device.

9. MR probe head according to any one of the claims 6 through 8, **characterized in that** for cooling the thermal stage (25) of the RF line coupling elements, a heat exchanger (26) is provided which is disposed in the feed line of the second cooling circuit or through the return line of the first cooling circuit.

10. MR probe head according to any one of the claims 6 through 9, **characterized in that** the thermal stage (23) has a temperature below the preamplifier temperature during operation.

11. MR probe head according to any one of the preceding claims, **characterized in that** the coupling comprises a vacuum connection (31) for coupling to a vacuum line (38).

12. MR probe head according to any one of the preceding claims, **characterized in that** the connecting means is designed as a mechanically flexible connecting line (8) with mechanically flexible RF and cooling lines (9a, 9b, 10).

13. MR probe head according to any one of the preceding claims, **characterized in that** one or more RF lines (10, 52) are associated with one single cooling line (9a, 9b, 53a, 53b), and each form, together with the associated cooling line (9a, 9b, 53a, 53b), one line package, and the RF lines (10, 52), associated with the cooling line (9a, 9b, 53a, 53b) of one single line package are thermally connected to each other in preferably regular intervals via coupling elements (11) having good thermal conductivity.

14. MR probe head according to one of the claims 12 or 13, **characterized in that** the cold parts of the connecting line (8), in particular the cooling lines (9a, 9b) and the RF lines (10) are disposed for thermal insulation in a vacuum within at least one flexible outer jacket.

15. MR probe head according to any one of the preceding claims, **characterized in that** the antenna system is operated at a lower temperature than the preamplifier (16).

16. MR probe head according to any one of the claims 2 through 15, **characterized in that** the preamplifier (16) comprises several parallel preamplifier channels, in particular, 2, 3, 4, 6, 8, 12 or 16 parallel channels for the same nucleus to be examined, in particular 1H.

17. MR probe head according to any one of the claims 2 through 16, **characterized in that** the preamplifier (16) comprises channels for amplifying the signals of the nuclei 31P, 13C, 23Na, 19F, 170, 129Xe or 2H.

18. MR system with an MR probe head according to any one of the preceding claims.

19. MR system according to claim 18, **characterized in that** it is an MRI or NMR system.

## Revendications

1. Tête de mesure pour la résonance magnétique (= RM)
avec un dispositif de détection (3) comprenant au moins un système d'antenne refroidi cryogéniquement par un dispositif de refroidissement,
ainsi qu'avec un préamplificateur refroidi (16) dans un carter de préamplificateur qui est disposé de manière localement séparée du dispositif de détection (3), et
avec un équipement de liaison thermiquement isolant via lequel le dispositif de détection (3) et le carter de préamplificateur sont reliés ensemble, l'équipement de liaison comprenant au moins une conduite de refroidissement (9a, 9b, 53a, 53b) pour l'amenée et/ou le retour d'un fluide de refroidissement ainsi qu'au moins une ligne HF (10, 52) pour la transmission des signaux électriques,
**caractérisée en ce**
**que** l'équipement de liaison, y compris ses lignes HF et ses conduites de refroidissement (10, 52, 9a, 9b, 53a, 53b), peut être séparé du carter de préamplificateur au moyen d'un accouplement.

2. Tête de mesure RM selon la revendication 1, **caractérisée en ce qu'**il s'agit d'une tête de mesure pour des applications d'imagerie par résonance magnétique (= IRM) ou pour la spectroscopie par résonance magnétique nucléaire (= RMN).

3. Tête de mesure RM selon l'une des revendications 1 ou 2, **caractérisée en ce qu'**il est prévu au moins deux conduites de refroidissement (9a, 9b, 53a, 53b) qui font partie d'un premier circuit de refroidissement.

4. Tête de mesure RM selon l'une des revendications précédentes, **caractérisée en ce que** l'accouplement présente un dispositif de couplage de fluide avec des éléments de couplage de fluide (29, 30) pour coupler ladite au moins une conduite de refroidissement (9a, 9b, 53a, 53b) qui conduit au dispositif de détection (3) à au moins une section de conduite de refroidissement (54a, 54b) côté carter de préamplificateur, ainsi qu'un dispositif de couplage de ligne HF (32), le dispositif de couplage de ligne HF (32) comprenant au moins un premier élément de couplage de ligne HF, en particulier un connecteur HF (39) côté système d'antenne, et au moins un deuxième élément de couplage de ligne HF, en particulier une douille HF (40), pour coupler les lignes HF (10,52) à l'entrée de signaux du préamplificateur (16).

5. Tête de mesure RM selon la revendication 4, **caractérisée en ce que** pour au moins une paire de premiers et deuxièmes éléments de couplage HF (39, 40) il est prévu un élément à ressort (42) qui presse l'un contre l'autre le premier élément de couplage HF et le deuxième élément de couplage HF associé.

6. Tête de mesure RM selon l'une des revendications 4 ou 5, **caractérisée en ce que** les éléments de couplage HF et/ou une enveloppe sous vide (46) qui entoure les premiers éléments de couplage HF sont refroidis par un étage thermique (25).

7. Tête de mesure RM selon la revendication 6, **caractérisée en ce que** l'étage thermique (25) des éléments de couplage de ligne HF (39, 40) est relié thermiquement à un échangeur de chaleur (24) du préamplificateur (16), à un étage thermique (23) du préamplificateur ou au préamplificateur (16) lui-même.

8. Tête de mesure RM selon l'une des revendications 3 à 7, **caractérisée en ce que** l'électronique du préamplificateur refroidi (16) est refroidie par un deuxième circuit de refroidissement séparé de ladite au moins une conduite de refroidissement (9a, 9b, 53a, 53b), le premier et le deuxième circuits de refroidissement étant refroidis par le même dispositif de refroidissement.

9. Tête de mesure RM selon l'une des revendications 6 à 8, **caractérisée en ce que** pour refroidir l'étage thermique (25) des éléments de couplage de ligne HF, il est prévu un échangeur de chaleur (26) qui est disposé dans la conduite de départ du deuxième circuit de refroidissement ou à travers la conduite de retour du premier circuit.

10. Tête de mesure RM selon l'une des revendications 6 à 9, **caractérisée en ce que** l'étage thermique (23) présente, en fonctionnement, une température inférieure à la température du préamplificateur.

11. Tête de mesure RM selon l'une des revendications précédentes, **caractérisée en ce que** le couplage comprend un raccord de vide (38) pour le couplage à une ligne de vide (38).

12. Tête de mesure RM selon les revendications précédentes, **caractérisée en ce que** l'équipement de liaison est réalisé sous la forme d'une conduite de liaison (8) mécaniquement flexible avec des lignes HF (10) et des conduites de refroidissement (9a, 9b) mécaniquement flexibles.

13. Tête de mesure RM selon l'une des revendications précédentes, **caractérisée en ce que** qu'une ou plusieurs lignes HF (10, 52) sont chaque fois assignées à une conduite de refroidissement individuelle (9a, 9b, 53a, 53b) et forment conjointement avec la conduite de refroidissement assignée un paquet de conduites, et que les lignes HF (10, 52) assignées à la conduite de refroidissement (9a, 9b, 53a, 53b) d'un paquet de conduites individuel sont reliées ensemble thermiquement à intervalles, de préférence réguliers, par des éléments de couplage (11) ayant une bonne conduction thermique.

14. Tête de mesure RM selon l'une des revendications 12 à 13, **caractérisée en ce que** les parties froides de la ligne de liaison (8), en particulier les conduites de refroidissement (9a, 9b) ainsi que les lignes HF (10), sont disposées, pour l'isolation thermique, dans un vide à l'intérieur d'au moins une enveloppe extérieure flexible.

15. Tête de mesure RM selon l'une des revendications précédentes, **caractérisée en ce que** le système d'antenne fonctionne à une température plus basse que le préamplificateur (16).

16. Tête de mesure RM selon l'une des revendications 2 à 15, **caractérisée en ce que** le préamplificateur (16) comprend plusieurs canaux de préamplification parallèles, en particulier 2, 3, 4, 6, 8, 12 ou 16 canaux parallèles pour le même noyau à étudier, en particulier 1H.

17. Tête de mesure RM selon l'une des revendications 2 à 16, **caractérisée en ce que** le préamplificateur (16) comprend des canaux pour l'amplification des signaux des noyaux 31P, 13C, 23Na, 19F, 170, 129Xe ou 2H.

18. Système RM avec une tête de mesure RM selon l'une des revendications précédentes.

19. Système RM selon la revendication 18, **caractérisée en ce qu'**il s'agit d'un système IRM ou RMN.
